(19) Europäisches Patentamt
European Patent Office
Office européen des brevets

(11) Publication number: **0 356 352 A2**

(12) # EUROPEAN PATENT APPLICATION

(21) Application number: **89420301.7**

(22) Date of filing: **10.08.89**

(51) Int. Cl.[5]: **H 01 L 39/24**
C 04 B 35/00

(30) Priority: **25.08.88 US 236420**

(43) Date of publication of application:
**28.02.90 Bulletin 90/09**

(84) Designated Contracting States:
**AT BE CH DE ES FR GB GR IT LI LU NL SE**

(71) Applicant: **EASTMAN KODAK COMPANY (a New Jersey corporation)**
**343 State Street**
**Rochester New York 14650 (US)**

(72) Inventor: **Lelental, Mark c/o EASTMAN KODAK COMPANY**
**Patent Department 343 State Street**
**Rochester New York 14650 (US)**

**Romanofsky, Henry Joseph c/o EASTMAN KODAK COMPANY**
**Patent Department 343 State Street**
**Rochester New York 14650 (US)**

(74) Representative: **Parent, Yves et al**
**Kodak-Pathé Département Brevets et Licences Centre de Recherches et de Technologie Zone Industrielle**
**F-71102 Chalon-sur-Saône Cédex (FR)**

(54) **Yttrium rich conductive articles and processes for their preparation.**

(57) A process forming an article comprised of a substrate and an electrically conductive thin film comprised of a mixture of rare earth alkaline earth oxide crystalline phases is disclosed. The process comprises applying to a substrate a solution comprising metal oxide precursors consisting essentially of a solvent and metal-ligand compounds of each of rare earth, alkaline earth, and copper containing thermally decomposable ligands and, in the presence of oxygen, heating the precursors to form the crystalline thin film on the substrate. The rare earth and alkaline earth are applied to the substrate in an atomic ratio greater than 1.0:2, and the electrically conductive rare earth alkaline earth copper oxide is heated to a temperature of less than 1050°C to form a mixture of $R_1A_2C_3$ and $R_2A_1C_1$ crystalline phases, where R, A, and C represent rare earth, alkaline earth, and copper, respectively.

FIG.I

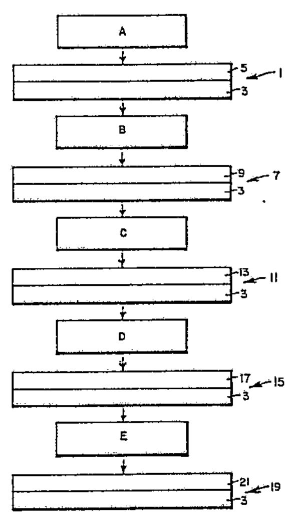


EP 0 356 352 A2

## Description

# YTTRIUM RICH CONDUCTIVE ARTICLES AND PROCESSES FOR THEIR PREPARATION

The present invention relates to articles having patterned conductive coatings, to processes for preparing these articles, and to useful intermediate articles. In certain preferred forms this invention relates to articles having patterned superconductive coatings and processes for their preparation.

The term "superconductivity" is applied to the phenomenon of immeasurably low electrical resistance exhibited by materials. Until recently superconductivity had been reproducibly demonstrated only at temperatures near absolute zero. As a material capable of exhibiting superconductivity is cooled, a temperature is reached at which resistivity decreases (conductivity increases) markedly as a function of further decrease in temperature. This is referred to as the superconducting transition temperature or, in the context of superconductivity investigations, simply as the critical temperature ($T_c$). $T_c$ provides a conveniently identified and generally accepted reference point for marking the onset of superconductivity and providing temperature rankings of superconductivity in differing materials. The highest temperature at which superconductivity (i.e., zero resistance) can be measured in a material is referred to as $T_O$.

A.H. Hamdi, J.V. Mantese, A.L. Micheli, R.C.O. Laugal, and D.F. Dungan, "Formation of thin-film High $T_c$ Superconductors by Metalorganic Deposition", Appl. Phys. Lett., 51 (25), 21 December 1987, reports the formation of 500 nm thin films of $YBa_2Cu_4O_z$ (z undetermined) on {100} $SrTiO_3$. A superconducting onset temperature ($T_c$) of 90°K was measured with $T_o$ occurring at 37 °K. When the process was repeated with $YBa_2Cu_3O_z$, both crystal sizes and $T_o$ where lower.

It is an object of this invention to provide a process comprising applying to a substrate a solution comprising metal oxide precursors consisting essentially of a solvent and metal-ligand compounds of each of rare earth, alkaline earth, and copper containing thermally decomposable ligands and, in the presence of oxygen, heating the precursors to form a mixed oxide thin film on the substrate of a crystalline electrically conductive rare earth alkaline earth copper oxide which produces thin film articles exhibiting improved conductivity characteristics.

The object is achieved by providing a process characterized in that the rare earth and alkaline earth are applied to the substrate in an atomic ratio greater than 1.0:2 and the electrically conductive rare earth alkaline earth copper oxide is heated to a temperature of less than 1050°C to form a mixture of $R_1A_2C_3$ and $R_2A_1C_1$ crystalline phases, where R, A, and C represent rare earth, alkaline earth, and copper, respectively.

It is another object of this invention to provide an article comprised of a substrate and an electrically conductive crystalline rare earth alkaline earth copper oxide exhibiting improved conductivity characteristics.

This object is achieved when the article is characterized in that the crystalline rare earth alkaline earth copper oxide is comprised of an $R_1A_2C_3$ crystalline phase formed over a $R_2A_1C_1$ crystalline phase, where R, A, and C represent rare earth, alkaline earth, and copper, respectively, with the proviso that the film is essentially free of any matrix of needle-like crystals of the the $R_2A_1C_1$ phase.

The present invention makes available to the art thin film articles (typically $<5$ microns thick) comprising a layer having a two phase ($R_1A_2C_3$ and $R_2AC$ phase) electrically conductive system which may be formed by firing at temperatures below the $RA_2C_3O_{7-x}$ decomposition temperature. In addition the present invention makes available to the art an electrically conductive article providing a two phase coating on a support having a superconducting transition temperature in excess of what is generally observed for the single $R_1A_2C_3$ phase system. Further, these articles are capable of being fabricated in any of the most commonly employed geometrical forms and patterns of electrically conductive elements as well as elongated flexible articles such as are employed for the fabrication of leads and windings in electrical circuits.

These and other advantages of the invention can be better appreciated by reference to the following detailed description of preferred embodiments considered in conjunction with the drawings, in which

Figure 1 is schematic diagram showing process steps and articles produced thereby;

Figure 2 is a schematic diagram of an arrangement for coating an elongated flexible substrate;

Figure 3 is a schematic diagram of process steps and articles formed thereby capable of forming a patterned conductor on a substrate; and

Figure 4 is a family of plots of resistance as normalized for the resistance at 150°K versus temperature in degrees Kelvin for films having various yttrium concentrations.

Figure 5 is a family of plots of $T_o$ (°K) vs. sintering temperature for films having various yttrium concentrations.

Figure 6 is a plot of observed $T_o$ (°K) of the conductive films vs. the yttrium concentration.

The present invention has as its purpose to make available electrically conductive articles exhibiting a rare earth alkaline earth copper oxide superconductive thin film ($<5$ µm) coated on a substrate and having improved $T_c$. The term "mixed rare earth alkaline earth copper oxide" refers to a composition of matter in the form of a mixture containing at least one rare earth element, at least one alkaline earth element, copper, and oxygen in the form of oxides and/or carbonates which are decomposable to form oxides. The rare earths contemplated for use in the practice of the invention are those known to form a conductive $R_1A_2C_3$ crystalline oxide phase (where R, A, and C represent rare earth, alkaline earth, and copper, respectively)—i.e., yttrium and elements of the lanthanide series, e.g., lanthanum, neodymium, samarium, europium, gadolinium, dysprosium, holmium, erbium, thulium, ytterbium, and lutetium. The term "alkaline earth" indicates elements of Group 2 of the Periodic Table of elements as adopted by the American Chemical Society capable of forming a

$R_1A_2C_3$ crystalline oxide phase, e.g., calcium, strontium and barium. Yttrium and barium are preferred rare earth and alkaline earth elements, respectively, for the practice of this invention.

A thermally decomposable metal-ligand layer generally refers to a metal ligand layer which decomposes upon heating to gaseous products and a film of the metal, metal oxide or metal carbonate.

The term mixed oxide layer represents a mixture of oxides of the various metals comprising the layer. Such metal oxides are formed by thermal decomposition of metal-ligand compounds. While most useful metal-ligand compounds (e.g., metalorganic compounds) thermally decompose to form metal oxides, some metalorganic compounds, in particular some alkaline earth organic compounds form metal carbonates on decomposition. Higher temperatures are then required to convert the carbonates to oxides. Consequently, the term mixed metal oxide as used herein includes compositions which may comprise one or more carbonates.

In keeping with the established practice in the ceramics art of shortening lengthy chemical names of mixed metal oxides by substituting acronyms based on the first letters of the metals present, the term "RAC" is hereinafter employed to indicate generically rare earth-alkaline earth-copper oxides. When it is intended to designate specifically a lanthanide or yttrium as the rare earth component, L or Y, respectively, is substituted for R; and when it is intended to designate specifically strontium or barium as the alkaline earth component, S or B, respectively, is substituted for A. Also, to distinguish a mixture of oxides from the crystalline oxide compounds obtained upon high temperature heating of the mixed oxides, such resulting compounds may be designated as rare earth-alkaline earth cuprates.

Except as otherwise noted, all steps in the preparation of electrically conductive articles according to this invention are understood to be practicable in air at atmospheric pressure. It is, of course, recognized that increasing the proportion of ambient oxygen present or operation at elevated pressures, used separately or together, is generally compatible with the practice of this invention and can be employed, although not required.

The present invention can be appreciated by the schematic diagram shown in Figure 1. In Step A of the preparation process, onto a substrate is coated a solution consisting essentially of a volatilizable film forming solvent and metal-ligand compounds of each of rare earth, alkaline earth, and copper containing at least one thermally decomposable ligand. The solution is characterized in that it has an excess of rare earth-ligand as compared with the stoichiometric rare earth ratio present in a $R_1A_2C_3$ material. The resulting coated article 1 as schematically shown consists of substrate 3 and a layer 5 formed by mixed RAC oxide precursors (metal-ligand compounds) and film forming solvent. The layer 5 and subsequent layers formed therefrom by further processing maintain the excess rare earth content.

In Step B article 1 is heated to a temperature sufficient to decompose the ligands and to volatilize the film forming solvent. The element 7 resulting consists of substrate 3 and a mixed RAC oxide layer 9. In its mixed form the RAC oxide coating exhibits relatively low levels of electrical conductivity.

To convert the mixed RAC oxide layer to a more highly conductive form it is necessary to induce RAC compound formation and crystal growth of the RAC compound layer. In Step C the article 7 is heated to a temperature sufficient to convert the article 7 comprising the mixed RAC oxide layer 9 to a more electrically conductive article 11 comprising a multiphase cuprate crystalline layer 13 having a $R_1A_2C_3$ phase compound and a $R_2A_1C_1$ phase compound in crystalline form.

At slow heating rates it is observed that initial crystallization of the mixed RAC oxide layer 9 occurs in two stages—crystal nucleation and crystal growth of $R_1A_2C_3$ phase and $R_2A_1C_1$ phase crystals. It is in some instances preferred to achieve crystal nucleation at a somewhat different temperature than is employed for crystal growth. Where faster heating rates are employed, the formation of the multiphase RAC system need not follow the above sequence.

As indicated, the present invention is characterized in that the concentration of rare earth present in the layer 5 and subsequent layers formed therefrom is greater than one, that is, the rare earth concentration is in excess of that required to form a $R_1A_2C_3$ crystalline oxide phase. The present invention is further characterized in that the mixed metal oxide layer is converted to a continuous, conductive multiphase crystalline compound layer comprising both $R_1A_2C_3$ and $R_2A_1C_1$ crystalline phases which is essentially devoid of any interlaced matrix of elongated needle-like crystals of the $R_2A_1C_1$ phase, by heating the rare earth rich mixed oxide to temperatures below the decomposition temperature of the $R_1A_2C_3$ phase and preferably below the melting point of such phase.

Step D entails controlled cooling of the crystalline RAC compound layer from its crystallization temperature. By slowing the rate of cooling of the crystalline RAC compound layer imperfections in the crystal lattices can be reduced and electrical conductivity, which is favored with increasing order in the crystal structure, is increased. Cooling rates of 25°C per minute or less are contemplated until the crystalline RAC layer reaches a temperature of at least 500°C or, preferably, 200°C. Below these temperatures the lattice is sufficiently rigid that the desired crystal structure is well established. The article 15 produced is formed of the annealed crystalline RAC compound layer 17 on substrate 3.

While the article 15 exhibits high levels of electrical conductivity, in some instances further heating of the article 15 in an oxygen enriched atmosphere has been observed to increase electrical conductivity further. In addition to oxygen supplied from the ligands the oxygen forming the crystalline RAC compound layer is obtained from the ambient atmosphere, typically air. It is believed that in some instances, ambient air does not provide the proportion of oxygen needed to satisfy entirely the available crystal lattice sites.

Therefore, optional Step E entails heating the article 15 in an oxygen enriched atmosphere, preferably pure oxygen. The object is to equilibrate the RAC crystalline layer with the oxygen enriched atmosphere, thereby adding sufficient oxygen into the crystal lattice structure. Temperatures for oxygen enrichment of the crystalline RAC compound layer are above the minimum annealing temperatures employed in Step D described above. To be effective in introducing oxygen into the crystal lattice temperatures above those at which the lattice becomes rigid are necessary. The duration and temperature of heating are interrelated. Substantially complete oxygen equilibration can generally be realized at near minimum temperatures in about 1 hour.

In preparing RAC layers shown to be benefitted by oxygen enrichment of the ambient atmosphere Step E can be consolidated with either or both of Steps C and D. Oxygen enrichment is particularly compatible with Step D, allowing annealing out of crystal lattice defects and correction of crystal lattice oxygen deficiencies to proceed concurrently.

The final electrically conductive article 19 is comprised of a two phase crystalline, electrically conductive RAC layer 21 on substrate 3. Depending upon specific choices of materials and preparation techniques, the article 19 can exhibit a high superconducting transition temperature, herein employed to designate a $T_c$ of greater than 30° K and, more particularly, a $T_c$ greater than previously observed for the equivalent single phase system.

The process of this invention does not employ precursor compositions which are in proportion to the stoichiometric ratio of rare earth, alkaline earth, and copper present in the conductive $R_1A_2C_3$ phase as taught in the prior art. Instead, an excess of rare earth is employed. It is the presence of this excess of rare earth which gives rise to the polyphase film as described without firing at temperatures at or above the $R_1A_2C_3$ phase decomposition temperature.

A coating process particularly adapted to coating flexible substrates can be illustrated by reference to Figure 2, wherein an elongated flexible substrate 25 is unwound from a supply spool 27 and passed downwardly over a guide roller 29 into a reservoir 31. The reservoir contains a film forming solvent with metal-ligand compounds dissolved therein, as described above in connection with Step A, shown as a liquid body 33. The flexible substrate is drawn over a lower guide roller 35 while immersed in the liquid and then passed upwardly to a third guide roller 37.

As the flexible substrate is drawn upwardly it emerges from the liquid body bearing an annular thin, uniform surface layer corresponding to layer 5 in Figure 1. Between the reservoir and the third guide roller the coated substrate is drawn through a heating zone to complete in different regions of the heating zone process Steps B, C, D, and E sequentially, as previously described. To accommodate needs for different residence times within the various heating regions the lengths of the different regions can be adjusted. Additionally, residence time of a substrate within any heating region can be further increased by employing laterally diverting guides, so one or a number of coated substrate festoon-like path diversions are created within the heating region.

After passing over the third guide roller the substrate, bearing an annular crystalline electrically conductive RAC layer according to the present invention is wound onto a storage spool 39. Where the RAC layer is coated on a flexible substrate, it is preferred to maintain the thickness of the RAC layer at 2 µm or less, preferably 1.0 µm or less, so that it exhibits adequate flexibility. Flexing of the RAC layer required by guiding and spooling by can be reduced by increasing the radius of curvature imposed by the third guide roller and storage spool.

The arrangement shown in Figure 2 for applying a flexible RAC layer to a flexible substrate is, of course, merely illustrative of a number of approaches which can be employed to apply a RAC layer to a flexible substrate. Where it is more convenient to perform process steps B, C, D, and E in a horizontally offset rather than vertically offset spatial relationship, instead of applying the RAC precursors and film forming solvent by immersion of the substrate, other conventional coating approaches can be employed for application, such as roll coating, spraying, brushing, curtain coating, extrusion, or the like. It is generally preferred to avoid guide contact of the coated substrate between application of the RAC precursors and completion of Step B. However, once a solid RAC layer exists on the substrate, guide contact with the substrate within or between any one of process Step C, D, and E locations can be undertaken, as desired for convenient spatial orientation.

While flexible electrical conductors of extended length serve a variety of important applications, there are many other applications for electrical conductors, particularly those located on limited portions of substantially planar surfaces of substrates. Such applications include those served by conventional printed, integrated, and hybrid circuits. In such circuits limited, if any, flexibility of the electrical conductor is required, but an ability to define areally—i.e, pattern, the electrical conductor with a high degree of precision is in many instances of the utmost importance. The present invention is compatible with precise patterning of the electrical conductor on a substrate surface.

Patterning of an electrical conductor according to this invention is illustrated by reference to Figure 3. Substrate 3 is coated on its upper planar surface with a uniform RAC precursor layer 5 as described above in connection with process Step A to form initial coated article 1. Process Step B, described above, is performed on article 1 to produce article 7, described above, comprised of a mixed RAC oxide layer 9 and substrate 3.

The mixed RAC oxide layer lends itself to precise pattern definition and produces results generally superior to those achieved by patterning the mixed RAC oxide precursor layer from which it is formed or the crystalline RAC compound layer which is produced by further processing. The RAC precursor layer is often liquid before performing process Step B and is in all instances softer and more easily damaged in handling than the mixed RAC oxide layer. The crystalline RAC compound layer cannot be etched with the same boundary precision as the mixed RAC oxide layer, since etch rates vary from point to point based on local variations in the crystal faces and boundaries presented to the etchant. Patterning of either the RAC oxide precursor layer or the crystalline RAC compound layer is specifically recognized as a viable alternative to patterning the mixed RAC oxide layer for applications permitting more tolerance of conductor dimensions. For example, screen printing the RAC precursor layer on a substrate to form a printed circuit is specifically contemplated.

While the mixed RAC oxide layer can be patterned employing any conventinal approach for patterning metal oxides, for more precise edge definitions the preferred approach is to photopattern the mixed RAC oxide layer employing any of the photoresist compositions conventionally employed for the precise definition of printed circuit or integrated circuit conductive layers. In a preferred form of the process, a uniform photoresist layer 23 is applied to the mixed RAC oxide layer 9 as indicated by process Step B-1. The photoresist layer can be formed by applying a liquid photoresist composition to the substrate, spinning the substrate to insure uniformity of the coating, and drying the photoresist. Another approach is to laminate a preformed photoresist layer supported on a transparent film to the mixed RAC oxide layer.

The photoresist layer is then imagewise exposed to radiation, usually through a mask. The photoresist can then be removed selectively as a function of exposure by development. Positive working photoresists are removed on development from areas which are exposed to imaging radiation while negative working photoresists are removed only in areas which are not exposed to imaging radiation. Exposure and development are indicated by process Step B-2. Following this step patterned photoresist layer 23a is left on a portion or portions of the mixed RAC oxide layer 9. Although the patterned residual photoresist layer is for convenience shown of a simple geometrical form, it is appreciated that in practice the patterned photoresist can take any of a wide variety of geometrical forms, including intricate and thin line width patterns, with line widths ranging into the sub-micrometer range.

Following patterning of the photoresist layer, portions of the RAC layer which are not protected by the photoresist can be selectively removed, such as by etching or ion beam milling, as indicated by process Step B-3. This converts the mixed RAC oxide layer 9 to a patterned mixed RAC oxide layer 9a confined to areas corresponding to that of the photoresist.

Following patterning of the mixed RAC oxide layer the patterned photoresist is removed, as indicated by process Step B-4. The final article, as shown in Figure 3 consisting of the substrate 3 and patterned mixed RAC oxide layer 9a, is then further processed as indicated in Figure 1, picking up with process Step C. The crystalline RAC compound layer formed in the final product conforms to the patterned mixed RAC oxide layer.

In order to obtain an improved photoresist patterned article it is contemplated to employ an underlying lift-off layer, e.g., a CuO layer.

In the process of preparing a patterned article described above it is noted that once an article is formed having a mixed RAC oxide layer on a substrate it can be patterned to serve any of a wide variety of circuit applications, depending upon the circuit pattern chosen. It is therefore recognized that instead of or as an alternative to offering patterned or unpatterned crystalline RAC layer articles for sale a manufacturer can instead elect to sell articles with an unpatterned mixed RAC oxide layer, with or without an unpatterned photoresist layer, to subsequent fabricators. It will often be convenient in this instance to locate a removable layer or film over the mixed RAC oxide layer for its protection prior to further fabrication. The subsequent fabricator can undertake the patterned exposure and further processing required to produce a finished multiphase electrically conductive article.

To crystallize a mixed RAC oxide layer and to perform the optional, but preferred annealing and oxygen enrichment steps both the substrate and mixed RAC oxide layer are heated uniformly. This can be done employing any conventional oven. In some instances, however, either to protect the substrate from rising to the peak temperatures encountered by the RAC layer or simply to avoid the investment in an oven by fabricator, it is contemplated that the RAC layer will be selectively heated. This can be accomplished by employing a radiant heat source, such as a lamp—e.g., a quartz lamp. Lamps of this type are commercially available for achieving rapid thermal annealing of various conventional layers and can be readily applied to the practice of the invention. These lamps rapidly transmit high levels of electromagnetic energy to the RAC layer, allowing it to be brought to its crystallization temperature without placing the substrate in an oven.

A diverse approach for producing patterned electrical conductors can be practiced by employing article 7 comprised of the uniform mixed RAC oxide layer 9 and substrate 3 as a starting element. Instead of patterning the mixed RAC oxide layer followed by crystallization of the remaining portions of the layer, the mixed RAC oxide layer is imagewise addressed to produce compound formation and crystal growth and two phase formation selectively only in areas intended to be rendered electrically conductive. For example, by addressing the mixed RAC oxide layer with a laser, areas directly impinged by the laser beam can be selectively crystallized to a two phase electrically conductive form leaving the remaining mixed RAC oxide areas unaffected. To define the conductive pattern generated it is only necessary to control the path of the laser beam.

Where a manufacturer chooses to sell an article consisting of a uniform mixed oxide RAC layer on a substrate, this approach to patterning can be more attractive than the uniform heating processes described above, since no oven is required to reach the temperatures typically required for crystallization. The fabricator choosing laser patterning may, in fact, require no other heating equipment. Thus, a very simple approach to forming a crystalline RAC pattern is available.

It is, of course, recognized that additional heating for purposes of annealing or oxygen saturation can be undertaken, following lamp or laser crystallization, by heating in any desired manner.

Both lamp heating and laser scanning allow a broader range of substrates to be considered, particularly those which, though capable of withstanding ligand and solvent volatilization temperatures, are susceptible to degradation at crystallization temperatures. By choosing wavelengths in spectral regions to which the mixed RAC oxide layer is opaque or at least highly absorbing, direct radiant heating of the substrate can be reduced or eliminated. In this instance the bulk of the radiation is intercepted in the RAC layer before it reaches the substrate. The substrate can also be protected from direct radiant heating by choosing a substrate composition that is transparent to or minimally absorptive of the laser radiation. Since lasers emit coherent electromagnetic radiation of a single wavelength, high selectivity of absorption or transmission is much more readily achieved than when absorption or transmission must be averaged over a wavelength region of the spectrum.

In considering crystallization of a RAC layer by radiant energy to which the RAC layer is opaque or at least highly absorptive and employing a substrate which is substantially transparent to the radiant energy, whether supplied from a lamp or laser, advantages can be realized by supplying the radiant energy to the RAC layer through the substrate. Where a substantially transparent substrate is employed, little of the radiant energy is attenuated in traversing the substrate. The RAC layer adsorbs the radiant energy adjacent its interface with the substrate. Thus, crystallization of the RAC layer can be initiated at this interface. By choosing a substrate of a crystal structure and chemistry compatible with that of the crystals to be formed in the RAC layer, crystal growth in the RAC layer can occur epitaxially at the interface of the RAC layer and the substrate. Generally, in one form the substrate can be of the same crystalline form sought in the RAC layer—e.g., a $R_1A_2C_3$ crystalline form or a $R_2A_1C_1$ crystalline form. However, it is not essential that the substrate have the same crystal structure as the RAC layer for epitaxial deposition to occur. What is generally most important is that the substrate present a surface for deposition of the conductive crystalline RAC layer that at least approximates the spatial frequency of atoms favorable for epitaxy. For example, it is possible to slice a monocrystalline substrate so that it presents a planar surface having a frequency and spacing of oxygen atoms approximating that in the desired crystalline phase of the RAC layer. The spatial frequency of oxygen atoms at the surface of the substrate can be chosen to match or approximate that of a tetragonal $K_2NiF_4$ or $R_1A_2C_3$ crystalline form, for instance, even though the substrate takes a different crystalline form. Notwithstanding the foregoing, it has been found that a monocrystalline magnesia (periclase) substrate and particularly a MgO substrate having a {100} crystal surface is preferred.

To avoid coating imperfections the thickness of a mixed RAC oxide layer produced in a single process sequence is maintained at 1.5 µm or less, preferably 1.0 µm or less, and optimally 0.4 µm or less, a single process sequence being understood to constitute the steps described above for forming a mixed RAC oxide layer. By repeating the process sequence one or more times a mixed RAC oxide layer of any desired thickness can be built up. It is generally preferred to repeat this sequence three to ten times to achieve sufficient thickness to minimize substrate interaction effects.

While ideal substrates are those which remain chemically nonreactive during fabrication of the conductive crystalline RAC compound layer, in practice when RAC crystallization temperatures are encountered by the substrate at least some interaction of the RAC layer occurs with all but the most stable of substrates. In some instances less than hoped for levels of electrical conductivity have been observed, believed to be attributable to interaction of the crystallized RAC layer with its substrate at their mutual interface. Unwanted reductions in $T_c$ are believed to be unwanted manifestations of substrate interaction with the crystalline RAC compound layer. Such degradation has been observed for example, when employing alumina, silicon and quartz as the substrate material for RAC compound layers.

In any event, to minimize unwanted interaction of the RAC layer with the substrate it is specifically contemplated to interpose a barrier between the substrate and the RAC layer. It has been observed that each time the process sequence required for forming the mixed RAC oxide layer is repeated one or more times (preferably 3 to 10 times) before proceeding on to the crystallization step of the process, substrate or barrier interaction with the crystalline RAC compound layer is reduced, as reflected in its electrical conductivity properties, even where microscopic examination reveals individual grains or microcrystals extending from at or near the substrate to the top of the RAC layer. In this instance the portion of the crystalline RAC compound layer adjacent the substrate is acting as a barrier protecting the portion of the RAC layer remote from the substrate.

An alternative is to interpose between the substrate and the crystalline RAC compound layer a barrier of a different composition. The interposed barrier layer can itself take the form of a crystalline RAC compound layer, differing in the specific RAC composition chosen. In this instance the barrier layer can be viewed as a second crystalline RAC compound layer, which can, if desired, perform electrical conduction as well as acting as a barrier.

In other instances the barrier can be viewed as an extension of the substrate. For example, a ceramic substrate coated with a thin refractory metal layer or a semiconductor substrate coated with an oxide or nitride, each of which are in turn overcoated with a crystalline RAC compound layer, can be viewed as an article having a composite substrate supporting a crystalline RAC compound layer or an article having a unitary substrate, a crystalline RAC compound layer, and an interposed barrier.

To facilitate formation of the most highly uniform crystalline RAC compound layers it is preferred that the substrate itself be monocrystalline. Monocrystalline strontium titanate, alumina (sapphire) and magnesia (periclase) are all readily available substrate materials. Semiconductor wafers, particularly silicon and III-V compound wafers, may also constitute useful classes of monocrystalline substrates for the articles of this invention. However an appropriate barrier layer may be required.

A preferred barrier layer is magnesium oxide.

One barrier layer arrangement specifically contemplated for silicon substrates is wherein a barrier layer triad is interposed between a conductive layer and a silicon substrate. The barrier layer triad is comprised of a first triad layer located adjacent the silicon substrate consisting essentially of silica, a third triad layer removed from the silicon substrate consisting essentially of at least one Group 4 heavy metal (i.e., zirconium or hafnium) oxide, a second triad layer interposed between the first and third triad layers consisting essentially of a mixture of silica and at least one Group 4 metal oxide. This barrier layer protects the silicon substrate from contamination by the overlying conductive layer, particularly against copper contamination and protects the conductive layer from silicon contamination.

In the process of fabrication of this invention the formation of the desired RAC layer begins with the formation of a RAC precursor layer, such as layer 5 in article 1, shown in Figure 1. To form the precursor layer a solution of a film forming solvent, a rare earth metal compound, an alkaline earth metal compound, and a copper compound is prepared. Each of the rare earth, alkaline earth, and copper compounds consists of metal ion and one or more thermally decomposable ligands. A ligand oxygen atom bonded directly to a metal is often retained with the metal in the RAC layer, although other ligand oxygen atoms are generally removed. At least 95 percent of the ligands and their component atoms other than oxygen are preferably decomposed at temperatures of less than 600° C. On the other hand, to avoid loss of materials before or during initial coating of the metal-ligand compounds, it is preferred that the ligands exhibit limited, if any, volatility at ambient temperatures. Metal-ligand compounds having any significant volatility below their decomposition temperature are preferably avoided in the practice of this invention.

Metalorganic compounds, such as metal alkyls, alkoxides, β-diketone derivatives, and metal salts of organic acids—e.g., carboxylic acids, constitute preferred metal-ligand compounds for preparing RAC precursor coatings. The number of carbon atoms in the organic ligand can vary over a wide range, but is typically limited to less than 30 carbon atoms to avoid unnecessarily reducing the proportion of metal ions present. Carboxylate ligands are particularly advantageous in promoting metal-ligand solubility. While very simple organic ligands, such as oxalate and acetate ligands, can be employed in one or more metal-ligands compounds, depending upon the film forming solvent and other metal-ligand compound choices, it is generally preferred to choose organic ligands containing at least 4 carbon atoms. The reason for this is to avoid crystallization of the metal-ligand compound and to improve solubility. When heating is begun to remove the film forming solvent and ligands, the solvent usually readily evaporates at temperatures well below those required to volatilize the ligands. This results in leaving the metal-ligand compounds on the substrate surface. When the ligands have few carbon atoms or, in some instances, linear carbon atom chains, crystallization of the metal-ligand compounds occurs. In extreme cases crystallization is observed at room temperatures. This works against the molecular level uniformity of rare earth, alkaline earth, and copper ions sought by solution coating. Choosing organic ligands exhibiting 4 or more carbon atoms, preferably at least 6 carbon atoms, and, preferably, ligands containing branched carbon atom chains, reduces molecular spatial symmetries sufficiently to avoid crystallization. Optimally organic ligands contain from about 6 to 20 carbon atoms.

Instead of increasing the molecular bulk or modifying the chain configuration of organic ligands to avoid any propensity toward metalorganic compound crystallization on solvent removal, another technique which can be employed is to incorporate in the film forming solvent a separate compound to act as a film promoting agent, such as a higher molecular weight branched chain organic compound. This can, for example, take the form of a branched chain hydrocarbon or substituted hydrocarbon, such as a terpene having from about 10 to 30 carbon atoms.

The film forming solvents can be chosen from a wide range of volatilizable liquids. The primary function of the solvent is to provide a liquid phase permitting molecular level intermixing of the metalorganic compounds chosen. The liquid is also chosen for its ability to cover the substrate uniformly. Thus, an optimum film forming solvent selection is in part determined by the substrate chosen. Generally more desirable film forming properties are observed with more viscous solvents and those which more readily wet the substrate alone, or with an incorporated wetting agent, such as a surfactant, present.

It is appreciated that a wide variety of ligands, film promoting agents, and film forming solvents are available and can be collectively present in a virtually limitless array of composition choices.

Exemplary preferred organic ligands for metal organic compounds include metal 2-ethylhexanoates, naphthenates, neodecanoates, butoxides, isopropoxides, rosinates (e.g., abietates), cyclohexanebutyrates, and acetylacetonates, where the metal can be any of the rare earth, alkaline earth, or copper elements to be incorporated in the RAC layer. Exemplary preferred film forming agents include 2-ethylhexanoic acid, rosin (e.g., abietic acid), ethyl lactate, 2-ethoxyethyl acetate, and pinene. Exemplary preferred film forming solvents include toluene, 2-ethylhexanoic acid, n-butyl acetate, ethyl lactate, propanol, pinene, and mineral spirits.

As previously noted, the rare earth-ligand compound is incorporated in the film forming solvent in a proportion of rare earth to alkaline earth of >1.0:2; i.e., in excess of the stoichiometric ratio of rare earth present in the $RA_2C_3O_{7-x}$ compound. The ratio of alkaline earth to copper generally being 2:3 in accordance with the stoichiometric ratio of alkaline earth to copper in such compound. The rare earth, alkaline earth, and copper can each be reacted with the same ligand forming compound or with different ligand forming compounds. The metal-ligand compounds can be incorporated in the film forming solvent in any convenient concentration up to their saturation limit at ambient temperature. Generally a concentration is chosen which provides the desired crystalline RAC compound layer thickness for the process sequence. Where the geometry of the substrate permits, uniformity and thickness of the metal-ligand coating can be controlled by spinning the substrate after coating around an axis normal to the surface of the substrate which has been coated. A significant advantage of spin coating is that the thickness of the coating at the conclusion of spinning is determined by the contact angle and viscosity of the coating composition and the rate and time of spinning, all of which can be precisely controlled. Differences in the amount of the coating composition applied to the substrate are not reflected in the thickness of the final coating. Centrifugal forces generated by spinning cause excess material to be rejected peripherally from the article.

Although processing temperatures employed in forming the mixed RAC oxide layers and in subsequently converting the mixed oxide layers to crystalline layers can vary significantly, depending upon the specific RAC composition and crystal form under consideration, crystallization for forming the multiphase conductive crystalline layer comprising a $R_1A_2C_3$ phase and a $R_2A_1C_1$ phase is achieved at temperatures below the $R_1A_2C_3$ phase decomposition temperatures and may be achieved below the $R_1A_2C_3$ phase melting temperature. Melting points for RAC compositions vary, but are typically above 1000° C. The melting point of $Y_1B_2C_3$ phase crystals is about 1025° C.

A preferred technique for producing a high $T_c$ and high $T_o$ coating employing a rare earth rich mixed RAC oxide layer as taught herein of a YAC composition, and particularly of a YBC composition comprising both $YBa_2Cu_3O_{7-x}$ and $Y_2BaCuO_5$ crystalline phases is to heat the yttrium rich mixed oxide layer on the substrate to a temperature of less than the decomposition temperature of the $YBa_2CU_3O_{7-x}$ phase (>1050° C). Typically temperatures of from about 850° C to 1050° C are suitable with firing temperatures of from about 950° C to 1050° C being preferred. Following conversion of the mixed YBC oxide layer to the $Y_2B_1C_1$ and $Y_1B_2C_3$ crystalline phases, it is cooled slowly at a rate of 25° C or less per minute until it reaches a temperature of 750° to 400° C. The YBC layer is then held at this temperature or reheated to this temperature following cooling in the presence of an oxygen atmosphere until oxygen equilibration is substantially complete, typically about 20 to 120 minutes. High $T_c$ and $T_o$ coatings can be produced by the novel technique employing precursor solutions having an yttrium:barium:copper atomic ratio of from greater than 1.0 to 6:2:3, preferably greater than 1.0 to 3:2:3, respectively. These high $T_c$ and $T_o$ films are characterized by an absence of the matrix of interlaced needle-like crystals of the $Y_2B_1C_1$ phase obtained when heating a $Y_1B_2C_3$ phase layer to or above its decomposition temperature.

While the atomic ratio of yttrium can exceed the 3:2:3 ratio mentioned above, the practical limit of yttrium is determined by the characteristics of the film formed when decomposing the precursor solution to form a mixed oxide layer as well as the solubility limit of the yttrium organo-metallic compound employed in the precursor solution. For example, cohesion and adhesion of the mixed oxide film is degraded when the yttrium content exceeds a molar ratio of about 3:2:3. Further, when the percursor solutions are made more dilute in order to dissolve the yttrium-ligand compound the resulting film thickness is generally less than desirable.

Examples

The following $Y_x$:$Ba_2$:$Cu_3$ metalloorganic precursor solutions were prepared by dissolving the appropriate quantities of the respective yttrium, barium and copper carboxylates and rosin in a 2-ethylhexanoic acid-toluene solvent mixture. The solutions were refluxed for 5 minutes, allowed to cool to room temperature and then filtered using a 1.2 µm filter.

YBC-P1 $Y_1$: $Ba_2$:$Cu_3$

Following the above procedure 4.089g yttrium tri(2-ethylhexanoate), 8.125g barium di(cyclohexane butyrate) 8.26g copper di(2-ethylhexanoate) and 14.0g rosin were dissolved in a solvent mixture consisting of 30.4g 2-ethylhexanoic and 4.0g toluene. This solution results in an atomic ratio of Y:Ba:Cu of 1:2:3.

YBC-P2 $Y_{1.5}$:$Ba_2$:$Cu_3$

Utilizing 6.134g of the yttrium tri(2-ethylhexanoate) and otherwise following the quantities and procedure as set forth with respect to YBC-P1, a precursor solution having an atomic ratio of Y:Ba:Cu of 1.5:2:3 is formed.

YBC-P3 $Y_{2.0}$:$Ba_2$:$Cu_3$

Utilizing 8.178g of the yttrium tri(2-ethylhexanoate) and otherwise following the quantities and procedure set forth above, a precursor solution having an atomic ratio of Y:Ba:Cu of 2.0:2:3 is formed.

YBC-P4 $Y_{3.0}$:$Ba_2$:$Cu_3$

Utilizing 12.267g of the yttrium tri(2-ethylhexanoate) and otherwise following the quantities and procedure set forth above, a precursor solution having an atomic ratio of Y:Ba:Cu of 3:2:3 is formed.

Example 1

This example illustrates the preparation of an electrically conductive article prepared by forming a crystalline $YBa_2Cu_3O_{7-x}$ layer on a {100} face of a single crystal periclase (MgO) substrate utilizing the YBC-P1 stoichiometric precursor solution.

A coating of the YBC-P1 precursor solution was formed on the MgO substrate by spinning the MgO wafer at 3000 rpm for 20 seconds. The precursor coating was then heated in air to 650°C in a Fisher Model 495 ashing furnace to decompose the yttrium, barium and copper carboxylates. This coating-heating procedure was performed 7 times in sequence to build a mixed oxide layer of the desired thickness. The yttrium oxide ($Y_2O_3$)-copper oxide (CuO)-barium carbonate ($BaCO_3$) mixed oxide layer was converted to an electrically conductive crystalline $YBa_2Cu_3O_{7-x}$ single-phase film by heating in air to 1025°C in the ashing furnace. The sample was held at this temperature for 3 minutes and then allowed to cool slowly at a rate of 6°C per minute.

After cooling to room temperature the sample was heated in oxygen to 450°C, left to anneal at this temperature for 1 hour and then allowed to cool slowly at a rate of 6°C per minute. X-ray diffraction analysis of the Y-Ba-Cu layer confirmed that it exhibited a well defined perovskite structure corresponding to $Y_1Ba_2Cu_3O_{7-x}$ phase with a trace amount of $BaCO_4$ phase present. A standard four-probe technique was used to measure film resistance as a function of temperature. Contacts were made using gold bonding pads fabricated by pyrolysis of a gold organometallic precursor (Liquid Bright Gold® — Englehard Corp.). Results of electrical resistance measurements are shown in Figure 4.

As shown in Figure 4, the temperature dependence of the resistance of the single phase $YBa_2Cu_3O_{7-x}$ film is characterized by two distinct regions. In one region, which extends from 150°K to 85°K, the resistance increases as the temperature decreases. This temperature dependence is similar to that observed for semiconducting materials. In the second region ($T = <85°K$), one can observe the onset of a superconductive state ($T_c$), however the transition is broad and the sample reaches a zero resistance state $T_o$, at 55°K.

Examples 2-4

These examples illustrate the preparation of a high $T_c$, high $T_o$, electrically conductive article having a multiphase crystalline layer on a {100} face of a single crystal MgO substrate, the layer comprising a $YBa_2Cu_3O_{7-x}$ phase and a $Y_2BaCuO_5$ phase, utilizing precursors having excess yttrium with respect to the $YB_2C_3$ phase ratio.

These examples were prepared and characterized as described in Example 1, except that the precursor solutions YBC-P2 through YBC-P4 were employed wherein the ratio of yttrium with respect to the stoichiometric quantity of yttrium in accordance with the $YB_2C_3$ phase was increased as given in Table I.

TABLE I

| Example | Precursor Solution | Film Stoichiometry | | |
|---|---|---|---|---|
| | | Y | Ba | Cu |
| 2 | YBC-P2 | 1.5 | 2 | 3 |
| 3 | YBC-P3 | 2.0 | 2 | 3 |
| 4 | YBC-P4 | 3.0 | 2 | 3 |

It was found that the multiphase yttrium rich films exhibit higher superconducting temperatures ($T_c$ and or $T_o$) than the single phase $Y_1Ba_2Cu_3O_{7-x}$ composition. The temperature dependence of the resistance of the films formulated as described in Table I is shown in Figure 4. The yttrium rich films show sharper transitions and higher zero resistance temperatures ($T_o$). The films of Examples 3 and 4 also show higher onset temperatures ($T_c$). X-ray diffraction data of the $Y_{1.5}$-$Ba_2$-$Cu_3$-O, $Y_2$-$Ba_2$-$Cu_3$-O and $Y_3$-$Ba_2$-$Cu_3$-O films show the polyphase structures containing at least $Y_2BaCuO_5$ and $Y_1Ba_2Cu_3O_{7-x}$ phases.

Examples 6-25

These examples illustrate the effect of sintering temperature on the zero resistance temperature, $T_o$, of films prepared by the procedure set forth in Example 1, except that sintering temperatures of 1000°C, 1050°C, 1063°C, 1075°C, 1088°C and 1100°C were employed with each of the yttrium precursors (YBC-P1 through YBC-P4). Table II sets forth the composition and sintering temperature for each of these examples. The measured values of $T_o$ are plotted against the sintering temperature for each film composition and shown in Figure 5. It should be noted that at sintering temperatures above 1050°C the $YBa_2Cu_3O_{7-x}$ phase decomposes giving rise to a matrix of needle-like $Y_2BaCuO_5$ crystals with a $YBa_2Cu_3O_{7-x}$ phase on the surface thereof; the yttrium rich samples heated below the decomposition temperature also exhibit the $Y_2BaCuO_5$ phase but not with the matrix of needle-like crystals. Also, the stoichiometric YBC-P1 precursor, when sintered at a temperature below the $YBa_2Cu_3O_{7-x}$ decomposition temperature give rise to single phase $YBa_2Cu_3O_{7-x}$ films.

TABLE II

| Example | Precursor | Sintering Temperatures, °C |
|---|---|---|
| 6 | YBC-P1 | 1,000 |
| 7 | YBC-P1 | 1,050 |
| 8 | YBC-P1 | 1,063 |
| 9 | YBC-P1 | 1,075 |
| 10 | YBC-P1 | 1,100 |
| 11 | YBC-P2 | 1,000 |
| 12 | YBC-P2 | 1,050 |
| 13 | YBC-P2 | 1,088 |
| 14 | YBC-P3 | 1,000 |
| 15 | YBC-P3 | 1,050 |
| 16 | YBC-P3 | 1,063 |
| 17 | YBC-P3 | 1,075 |
| 18 | YBC-P3 | 1,088 |
| 19 | YBC-P3 | 1,100 |
| 20 | YBC-P4 | 1,000 |
| 21 | YBC-P4 | 1,050 |
| 22 | YBC-P4 | 1,063 |
| 23 | YBC-P4 | 1,075 |
| 24 | YBC-P4 | 1,088 |
| 25 | YBC-P4 | 1,100 |

As can be seen from Figure 5, higher zero resistance temperatures are achieved with the polyphase yttrium rich films as compared with the stoichiometric single phase $Y_1Ba_2Cu_3O_{7-x}$ film obtained when the crystallization firing temperature is under the decomposition temperature of the $Y_1Ba_2Cu_3O_{7-x}$ phase. Also, as is apparent from Figure 6, a plot of $T_o$ as a function of yttrium content for films fired at 1025°C, the higher the yttrium concentration the greater the observed $T_o$.

**Claims**

1. A process comprising
applying to a substrate a solution comprising metal oxide precursors consisting essentially of a solvent and metal-ligand compounds of each of rare earth, alkaline earth, and copper containing thermally decomposable ligands and
in the presence of oxygen heating the precursors to form a mixed oxide thin film on the substrate of a crystalline electrically conductive rare earth alkaline earth copper oxide,
characterized in that
the rare earth and alkaline earth are applied to the substrate in an atomic ratio greater than 1.0:2 and
the electrically conductive rare earth alkaline earth copper oxide is heated to a temperature of less than 1050°C to form a mixture of $R_1A_2C_3$ and $R_2A_1C_1$ crystalline phases, where R, A, and C represent rare earth, alkaline earth, and copper, respectively.

2. A process according to claim 1 further characterized in that the precursors are first heated to their thermal decomposition temperature and then heated to a higher temperature at which crystallization occurs.

3. A process according to claim 2 further characterized in that the steps of applying the precursors to the substrate and heating to their thermal decomposition temperature are repeated prior to heating to the higher temperature at which crystallization occurs.

4. A process according to any one of claims 1 to 3 inclusive further characterized in that the rare earth consists essentially of yttrium.

5. A process according to any one of claims 1 to 4 inclusive further characterized in that the alkaline earth consists essentially of barium.

6. A process according to any one of claims 2 to 5 inclusive further characterized in that crystallization is achieved by heating to a temperature in the range of from 850 to 1050°C.

7. A process according to claim 6 further characterized in that crystallization is achieved by heating to a temperature in the range of from 950 to 1050°C.

8. A process according to any one of claims 1 to 7 inclusive further characterized in that the substrate is alkaline earth oxide.

9. A process according to claim 8 further characterized in that the substrate is magnesium oxide.

10. An article produced according to the process of any one of claims 1 to 9 inclusive.

11. An article comprised a substrate and an electrically conductive crystalline rare earth alkaline earth copper oxide thin film characterized in that
the crystalline rare earth alkaline earth copper oxide is comprised of an $R_1A_2C_3$ crystalline phase formed over a $R_2A_1C_1$ crystalline phase, where R, A, and C represent rare earth, alkaline earth, and copper, respectively, with the proviso that the film is essentially free of any matrix of needle-like crystals of the the $R_2A_1C_1$ phase.

12. An article according to claim 11 further characterized in that said conducting thin film is less than 5 microns in thickness.

13. An article according to claim 11 or 12 further characterized in that the rare earth forming the thin film is yttrium.

14. An article according to any one of claims 11 to 13 inclusive further characterized in that the alkaline earth forming the thin film is barium.

15. An article according to any one of claims 11 to 14 inclusive further characterized in that the atomic ratio of rare earth to alkaline earth is in the range of from greater than 1.0 to 3:2.

16. An article according to any one of claims 11 to 15 inclusive further characterized in that the substrate is an alkaline earth oxide.

17. An article according to claim 16 further characterized in that the substrate is magnesium oxide.

18. An article according to claim 17 further characterized in that the substrate is monocrystalline magnesium oxide.

19. An article according to any one of claims 11 to 18 inclusive, further characterized in that the rare earth is yttrium, the alkaline earth is barium, and the atomic ratio of yttrium to barium is in the range of from greater than 1.0 to 3:2.

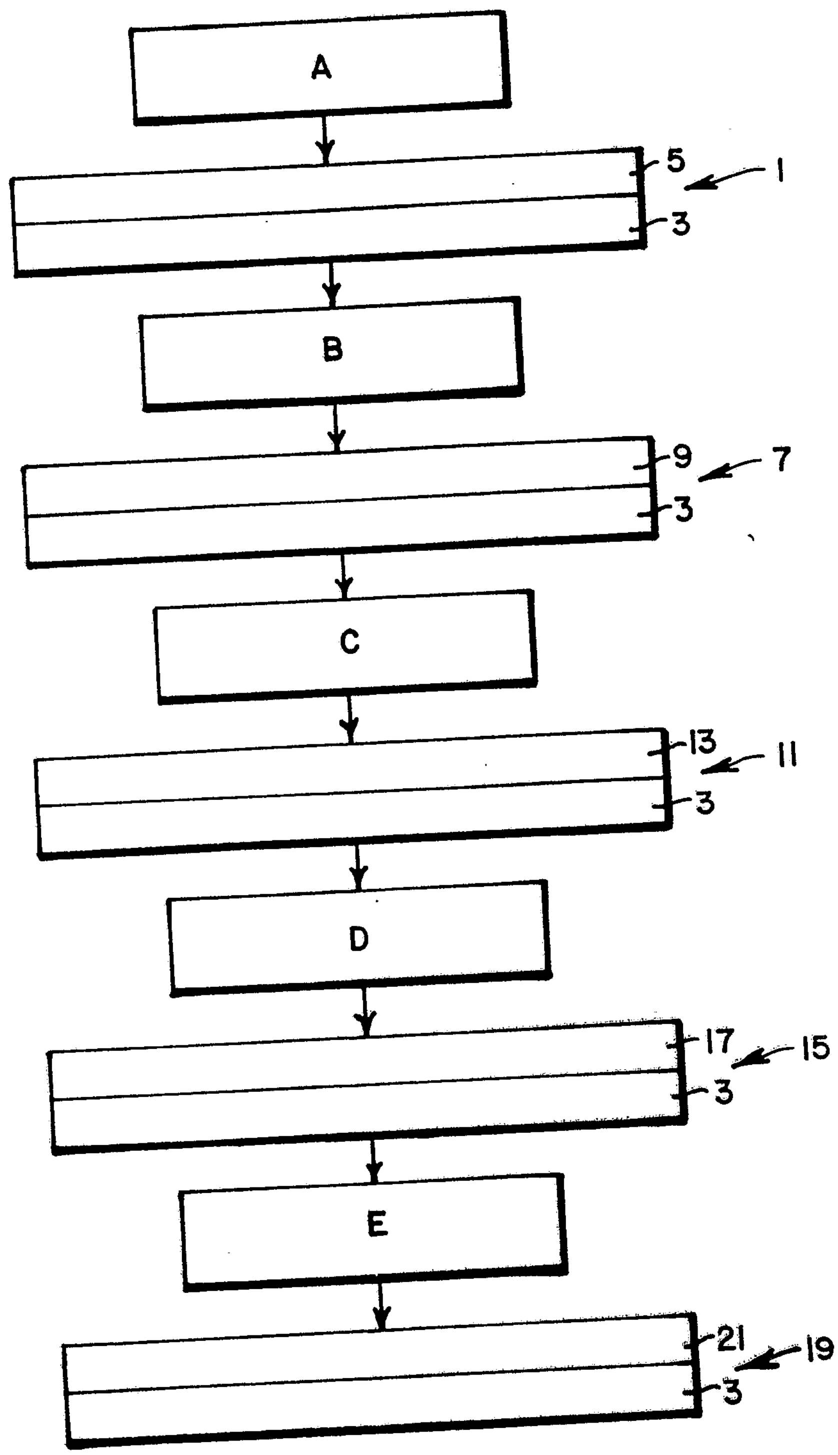


FIG.1

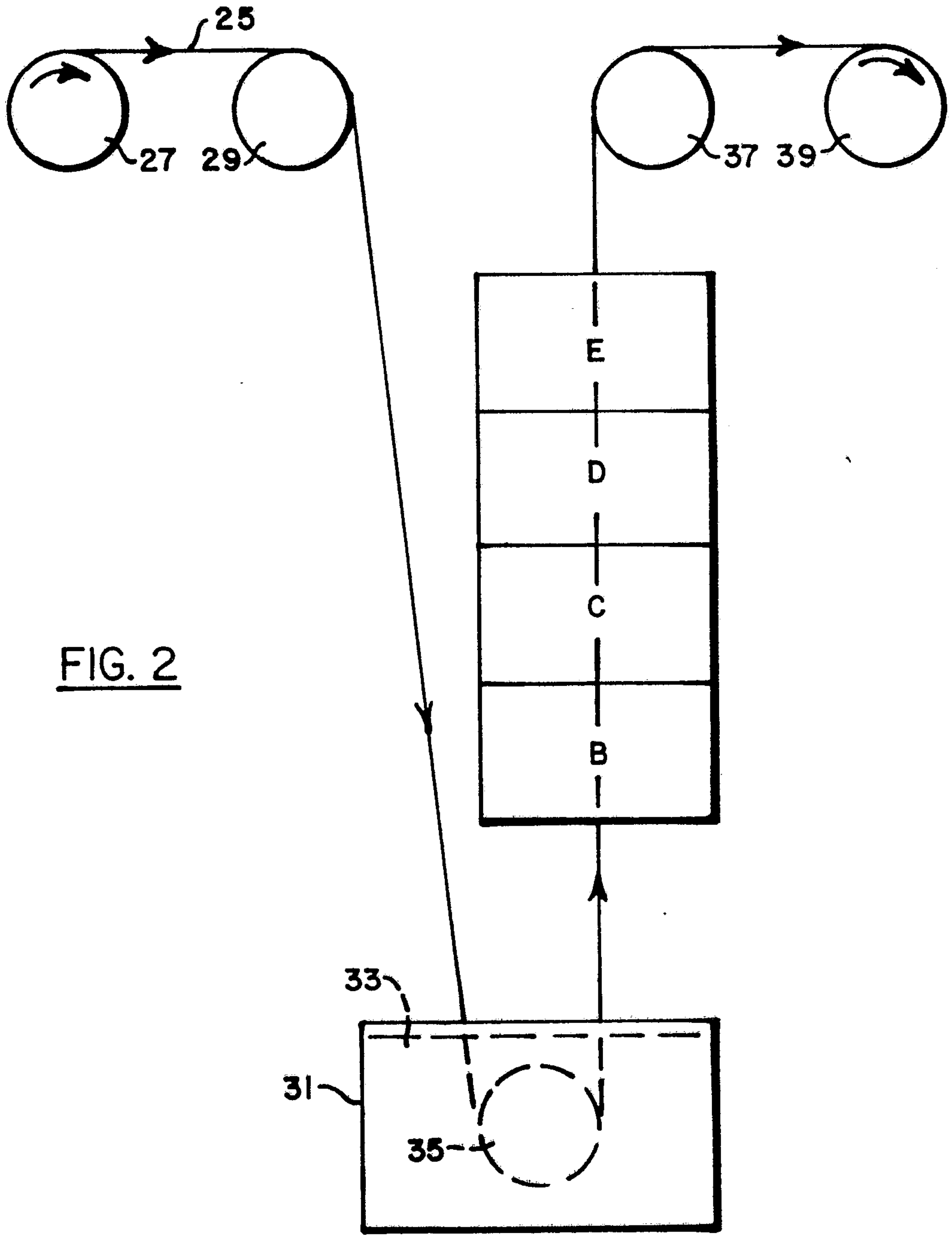


FIG. 2

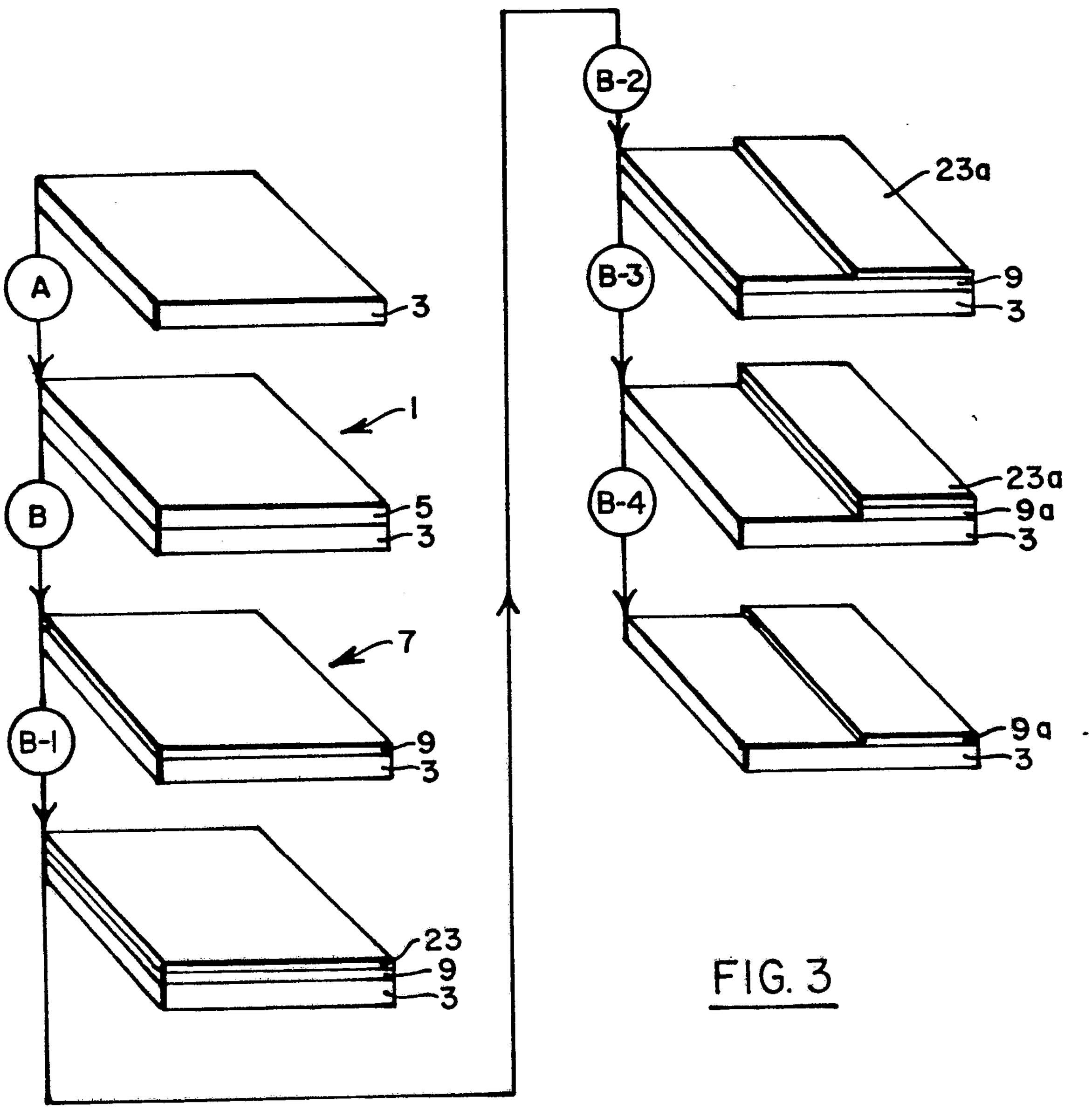


FIG. 3

FIG. 4

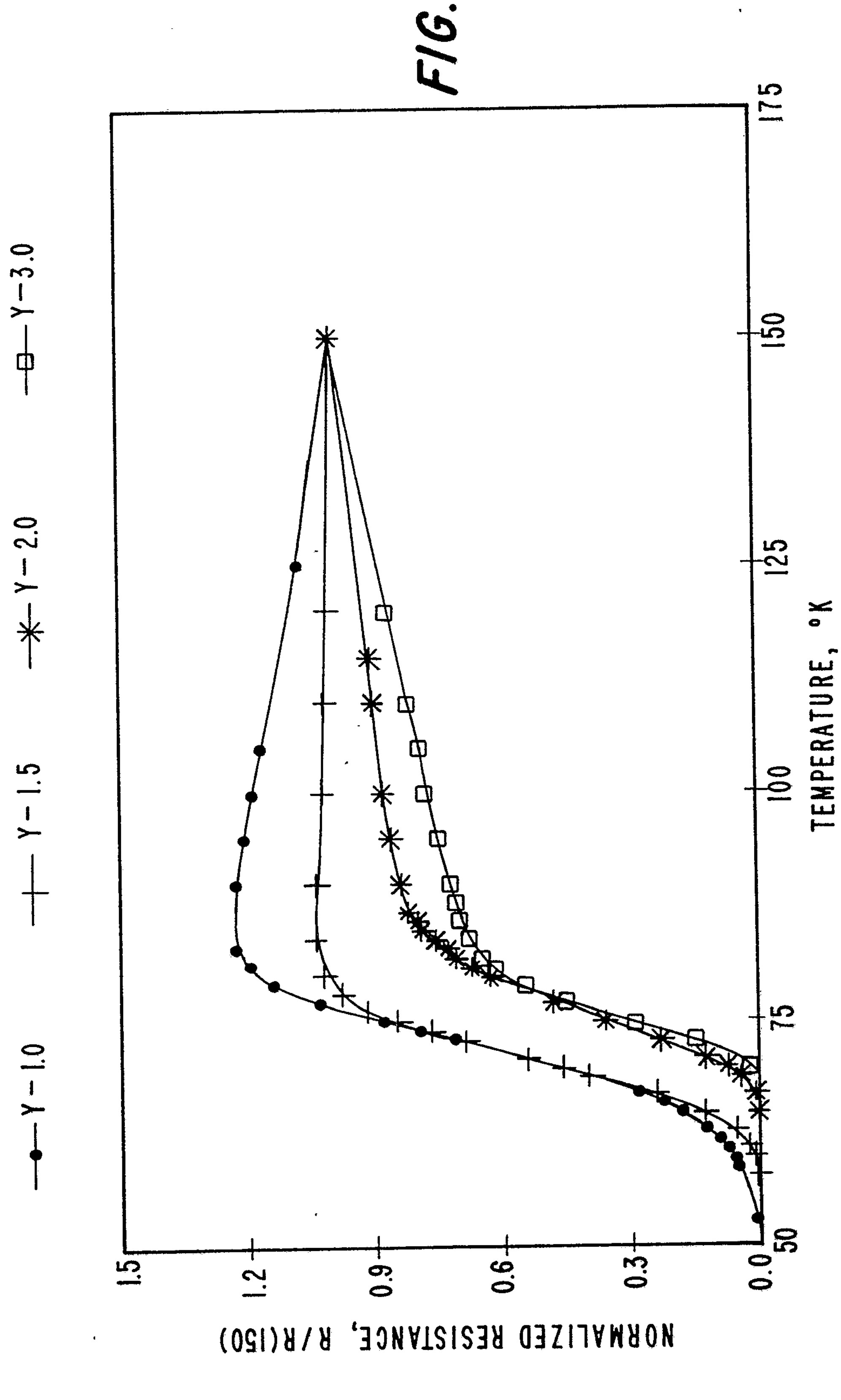

Y - 1.0
Y - 1.5
Y - 2.0
Y - 3.0
NORMALIZED RESISTANCE, R/R(150)
0.0
0.3
0.6
0.9
1.2
1.5
TEMPERATURE, °K
50
75
100
125
150
175

FIG. 5

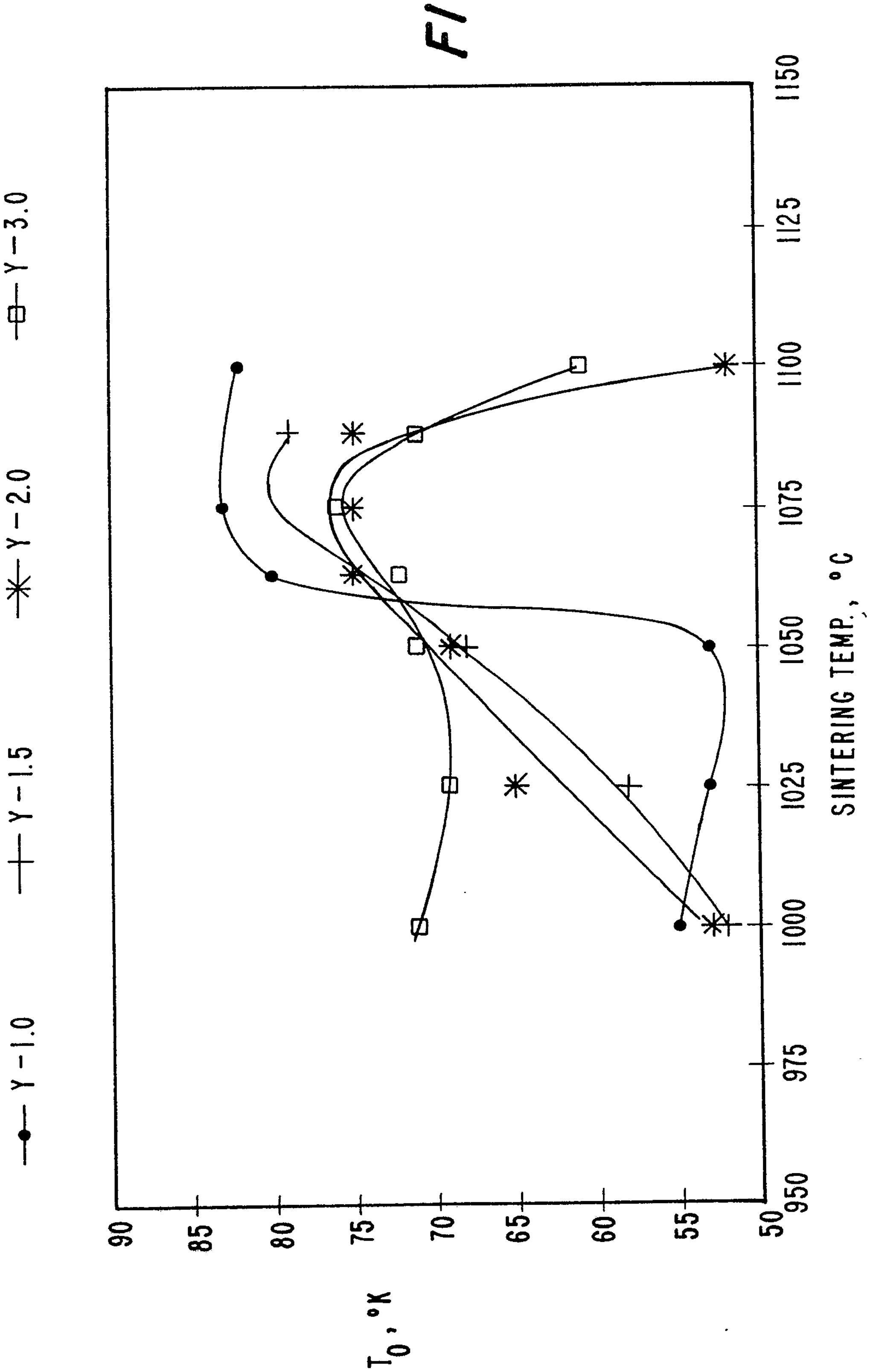

Y-1.0
Y-1.5
Y-2.0
Y-3.0
$T_0$, °K
90
85
80
75
70
65
60
55
50
950
975
1000
1025
1050
1075
1100
1125
1150
SINTERING TEMP., °C

FIG. 6

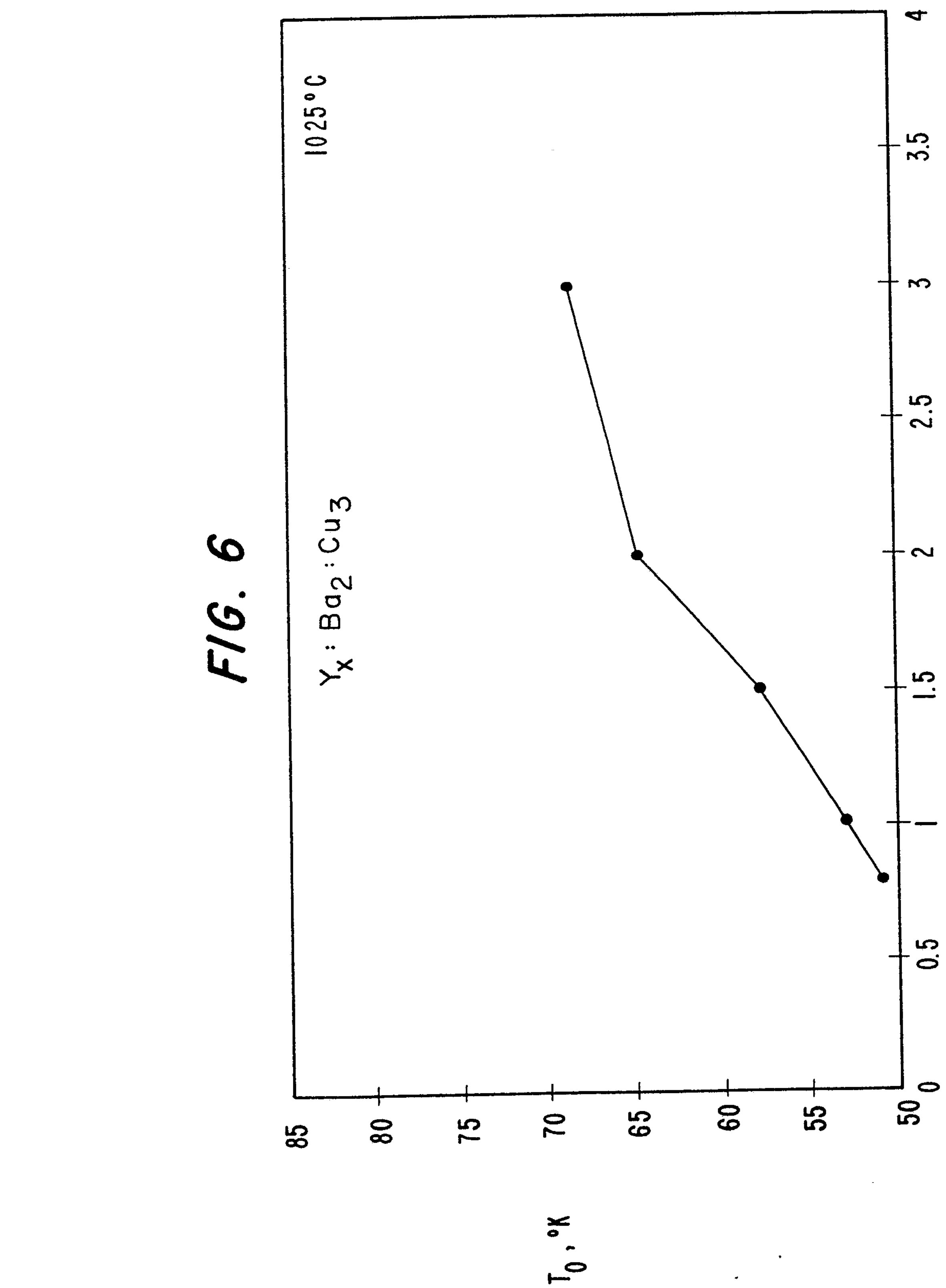
$Y_x : Ba_2 : Cu_3$
1025°C
$T_0$, °K
85
80
75
70
65
60
55
50
0
0.5
1
1.5
2
2.5
3
3.5
4
YTTRIUM, X